# EUROPEAN PATENT SPECIFICATION

(11) **EP 2 515 160 B1**
(45) Date of publication and mention of the grant of the patent: **21.06.2017**
(21) Application number: 11163568.6
(22) Date of filing: 22.04.2011
(51) Int. Cl.: G02F 1/13, G06F 1/16, H05K 3/30, H04M 1/02

(54) **Suspension and tolerance absorption subassembly for a display screen**
Träger- und Toleranzabsorptionsbaugruppe für einen Anzeigeschirm
Sous-assemblage d'absorption de suspension et de tolérance pour écran d'affichage

(43) Date of publication of application: 24.10.2012
(73) Proprietor: BlackBerry Limited, Waterloo, ON N2K 0A7 (CA)
(72) Inventor: Paleczny, Todd Robert, Waterloo Ontario N2L 3W8 (CA); Dehmoubed, Farzin, Waterloo Ontario N2L 3W8 (CA)
(74) Representative: Moore, Barry

(56) References cited:
- EP-A1- 0 642 089
- EP-A2- 0 503 427
- JP-A- 8 160 398
- JP-A- 63 313 130
- US-A- 5 774 199
- US-A1- 2002 003 595

## Description

### TECHNICAL FIELD

The technology described herein generally relates to a structure for supporting a display screen, and particularly to a shock-absorbing structure.

### BACKGROUND

Many modern electronic devices are equipped with a display screen, such as a liquid crystal display (LCD), that is electrically connected to a printed circuit board (PCB) within the device. The display screen may be secured to the printed circuit board using, for example, adhesives, clips or screws.

The display screen of an electronic device may be fragile, and therefore it may be of interest to protect the display screen from damage. The display screen of a mobile electronic device, such as a mobile communications device, a laptop computer, or a tablet computer, may be particularly vulnerable to damage due to the portable nature of the device. For example, a mobile communications device may be dropped by a user, and its display screen may be damaged as a result of the shock and/or vibration associated with the impact. A display screen with touch-screen functionality may also be vulnerable to damage resulting from pressure applied by the user's finger, for example.

A display screen of an electronic device may also be susceptible to damage resulting from pressure received from other components of the electronic device. For example, deviations from the nominal dimensions of one or more of components of the electronic device, including the display screen itself, may apply stress to the display screen.

Japanese patent publication 63313130 to Seiko Epson Corp discloses conductive rubber connectors that electrically connect a circuit board and a liquid crystal panel, where the conductive rubber connectors are inserted into grooves of an LED back light on the circuit board and a liquid crystal cell is fixed onto the connectors.

European patent application publication 0503427 to John Fluke MFG. CO., INC. discloses an LCD support bracket formed by a plurality of resilient cantilever beams projecting from a support to the lower edge of the LCD panel. The opposite edge of the LCD panel is supported by an elastomeric interconnection member that electrically connects the LCD panel to a circuit board on which the elastomeric interconnection panel is mounted.

United States patent application publication 2002/003595 to Yazawa discloses a backlighted liquid crystal display assembly mounted on a circuit substrate, where the assembly includes a liquid crystal display (LCD) screen panel, an electroluminescent (EL) panel for providing backlighting of the LCD screen panel, and a pair of electrical-interconnection rubber members, each having a plurality of conductive areas formed of conductive rubber material and plurality of insulating areas formed of an insulating rubber material and separating the conductive areas from each other. One of the rubber members has a first portion disposed and compressed between the LCD screen panel and the mounting surface of the circuit substrate and a second portion disposed and compressed between the LCD screen panel and the EL panel. The conductive areas of the rubber members are in contact with and provide electrical interconnection among electrical contact pads of the circuit substrate, the LCD screen panel and the EL panel.

### SUMMARY

A display screen, such as a liquid crystal display (LCD), of an electronic device may be supported by one or more subassemblies positioned between the display screen and a printed circuit board (PCB) or any mechanical support structure to which the display screen may be physically secured and electrically connected. Each subassembly is able to act as an independent suspension for the display screen and is able to cushion the display screen by absorbing mechanical tolerances and mechanical shock and vibration. These subassemblies may be used, for example, for suspension of a display screen of a mobile communications device, a laptop computer, a tablet computer, or any other electronic device having a display screen. Each suspension and tolerance absorption subassembly comprises a first member that may be affixed to a printed circuit board, and a second member having an outer portion that may bear against a rear surface of a display screen and a flexible inner portion interposed between the outer portion and the first member. In one example, the first member comprises steel, the outer portion of the second member comprises plastic, and the flexible inner portion of the second member comprises rubber. In another example, the flexible inner portion of the second member comprises silicone rubber co-molded to the outer portion of the second member. In a further example, first member and the second member are attached by a snap-fit assembly. Four suspension and tolerance absorption subassemblies may be mounted on a printed circuit board at positions substantially corresponding to four corners of a display screen to be cushioned by the subassemblies.

### BRIEF DESCRIPTION OF THE DRAWINGS

FIG. 1 is a top perspective view of an example suspension and tolerance absorption subassembly for a display screen;
FIG. 2 is an exploded view of the example suspension and tolerance absorption subassembly illustrated in FIG. 1;
FIG. 3 is a cross-sectional fragmentary view of the example suspension and tolerance absorption subassembly illustrated in FIG. 1;
FIG. 4 is a bottom perspective view of the example suspension and tolerance absorption subassembly illustrated in FIG. 1;
FIG. 5-1 is a perspective view of four example suspension and tolerance absorption subassemblies mounted to a printed circuit board;
FIG. 5-2 is a fragmentary perspective view of a display screen supported on a printed circuit board by one of the example suspension and tolerance absorption subassemblies illustrated in FIG. 1;
FIG. 6 is a cutaway perspective view of a display screen supported on a printed circuit board within an example electronic device by one of the example suspension and tolerance absorption subassemblies illustrated in FIG. 1; and
FIG. 7 is a block diagram of an example mobile communications device.

### DETAILED DESCRIPTION

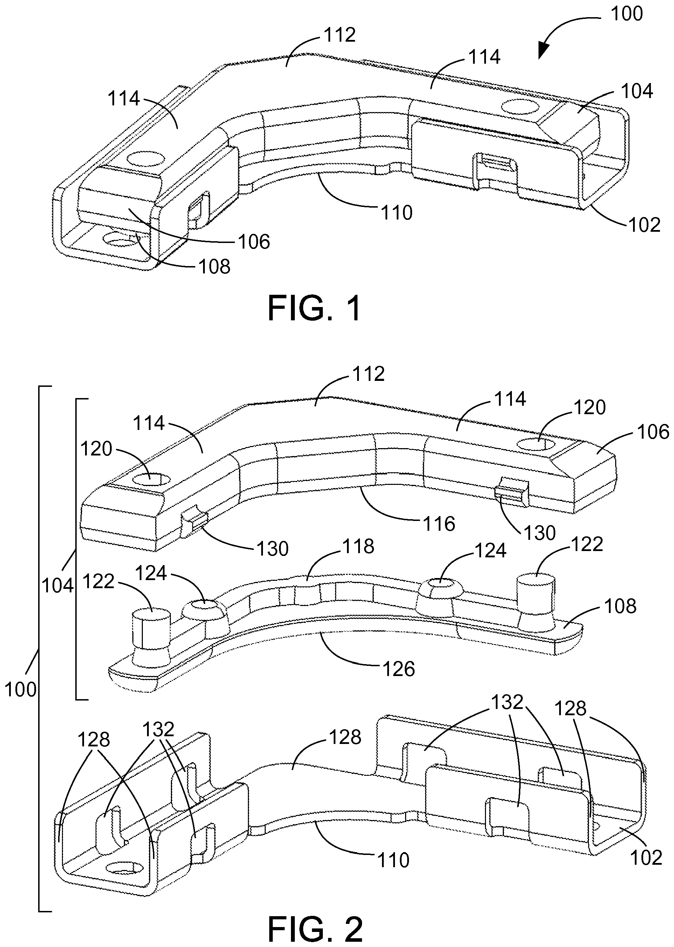

FIG. 1 illustrates a top perspective view of an example suspension and tolerance absorption subassembly for a display screen, hereinafter subassembly 100. Subassembly 100 comprises a first member 102 and a second member 104, the second member 104 having an outer portion 106 and a flexible inner portion 108. Inner portion 108 is "inner" in the sense that it is interposed between first member 102 and outer portion 106 of second member 104 (and consequently in the assembled subassembly 100 may be less easily visible than first member 102 and outer portion 106 of second member 104). An outer surface 110 of first member 102 is to be proximate to (typically in physical contact with, and in an illustrative implementation, affixed to) a PCB (not shown in FIG. 1), while an outer surface 112 of second member 104 is to be proximate to (typically in physical contact with) a rear surface of a display screen (not shown in FIG. 1). In general, the PCB (in addition to other functions) serves as a framework to which various components, such as the display screen, are secured. As will be discussed below, first member 102 may be considered to be an example of a first substantially rigid support means, outer portion 106 of second member 104 may be considered to be an example of a second substantially rigid support means, and inner portion 108 of second member 104 may be considered to be an example of a flexible (or resilient) cushioning means.

Suspension and tolerance absorption subassembly 100 is illustrated herein as having an L-shaped configuration with two arms 114. However, alternative configurations are contemplated, including, but not limited to, an I-shaped configuration and a square-shaped configuration. Overall dimensions may vary, but for a typical L-shaped configuration, each arm may be about seven millimeters long and about two millimeters wide, and the assembled subassembly may be about one and a quarter millimeters thick.

FIG. 2 illustrates an exploded perspective view of the example suspension and tolerance absorption subassembly illustrated in Fig. 1. In FIG. 2, first member 102 is shown apart from second member 104, and second member 104 is in turn shown with outer portion 106 apart from flexible inner portion 108.

Outer surface 110 of first member 102 of subassembly may be affixed to a PCB. For purposes of illustration, it will be assumed that first member 102 of subassembly may be affixed to the PCB by soldering, and first member 102 may be composed of any metal to which solder may be bonded. Examples of such metals include ferrous and non-ferrous metals, such as cold-rolled steel, stainless steel, tin-plated stock, or other coil stock. In one example, first member 102 is formed from cold-rolled steel #1008 or #1010 or from #304 stainless steel coil stock. First member 102 may be formed into the desired shape using progressive stamping according to traditional methods, for example. A material hardness of ¼, ½, ¾, or a full hard material may be used. Various other rigid and durable materials, such as plastics, may also be used, and they may be affixed to the PCB by a technique other than soldering (such as by an adhesive, spot welding, a mechanical connector such as a screw, etc.).

Outer surface 112 of second member 104 may bear against or be held in physical contact with a rear surface of the display screen by an external force. Adhesive, or another instrumentality for holding the components together, is usually not necessary to cause the display screen to bear against outer surface 112. The external force may be applied by, for example, connective elements that mount or otherwise physically secure the display screen to the PCB, as described below. Outer portion 106 of second member 104 is composed of a material that is typically hard, rigid and durable. Examples of such materials include polymer plastics such as polycarbonate (PC), acrylonitrile butadiene styrene (ABS), or PC/ABS blends. In one example, outer portion 106 of second member 104 is formed from Lexan siloxane copolymer resin. Outer portion 106 may be formed into the desired shape by injection molding, for example. Outer portion 106 of second member 104 may also be made of various metals or other hard, rigid or durable materials.

Inner portion 108 of second member 104 is composed of a flexible or resilient material (typically more flexible than outer portion 106), including, for example, silicone rubber. In one example, inner portion 108 of second member 104 is formed from liquid silicone rubber. The silicone rubber may be, for example, in the range of 30-70 durometer, such as 40 durometer. Inner portion 108 may be formed into the desired shape by injection molding, for example.

In general, the materials that make up subassembly 100 may be able to withstand reflow oven temperatures. For example, the materials that make up subassembly 100 may be able to withstand up to three passes in a reflow oven, including one pass for the front side of the PCB, one pass for the back side of the PCB and one spare pass. The capability of handling reflow oven temperatures is not essential to the concepts described herein, but this capability can make manufacturing more convenient and efficient.

An inner surface 116 of outer portion 106 may be bonded to an inner surface 118 of inner portion 108. This bond may be a mechanical bond or a chemical bond (with or without adhesive) or both. For example, inner portion 108 may be co-molded to outer portion 106, with a chemical bond being formed at the surface(s) of contact between portions 106 and 108, preventing their ready separation. A silicone inner portion 108 may be particularly suited for co-molding to a plastic outer portion 106 because silicone is able to maintain dimensional stability and temperature stability while still providing the flexibility to absorb mechanical tolerances and shock.

Outer portion 106 and inner portion 108 of second member 104 may be mechanically bonded to one another in any of many ways. For example, outer portion 106 may be injection-molded into a shape comprising one or more recesses (such as apertures, indentations, grooves, notches, etc.), and inner portion 108 may be co-molded to outer portion 106 into a shape comprising one or more mating or complementary protrusions, each one of the one or more protrusions filling or otherwise engaging a corresponding one of the one or more recesses. The engagement of the recesses of outer portion 106 with the protrusions of inner portion 108 may provide a mechanical bond between outer portion 106 and inner portion 108, preventing separation of portions 106 and 108. Other forms of mechanical bonding, such as the use of screws or clips or clamps to hold the outer portion 106 and inner portion 108 together, are usually unnecessary.

For example, as illustrated in FIG. 2, outer portion 106 may comprise holes 120, while inner portion 108 may comprise complementary protrusions 122. Inner portion 108 may also comprise additional protrusions 124 corresponding to recesses (not shown) in outer portion 106. Although not explicitly illustrated, additional and alternative protrusions and recesses may be used to provide mechanical bonding between outer portion 106 and inner portion 108 of second member 104. Holes 120 and any recesses in outer portion 106 may be formed, for example, as a result of the shape of the injection mold cavity used to form the outer portion 106. Protrusions 122 and additional protrusions 124 of inner portion 108 may be formed, for example, as a result of the shape of outer portion 106, to which inner portion 108 is co-molded.

Outer portion 106 and inner portion 108 may be formed by the same manufacturer or by different manufacturers. For example, outer portion 106 may be formed by a first manufacturer and delivered to a second manufacturer where inner portion 108 is formed. In some constructions, inner portion 108 may be formed and engaged to outer portion 106 in a single process. In other constructions, inner portion 108 and outer portion 106 may be formed apart, and mated in a separate assembly process.

A surface 126 of inner portion 108 of second member 104 is to be held proximate to (usually in contact with) an inner surface 128 of first member 102. In other words, the assembled second member 104 (which includes outer portion 106 and flexible inner portion 108) is to be mated to first member 102. Mating may be accomplished in any of several ways, including snap-fitting second member 104 to first member 102.

For example, as illustrated in FIG. 2, first member 102 may comprise one or more channel-shaped portions 128 (which may be formed, as depicted in FIG. 2, by side structures substantially perpendicular to outer surface 110 of first member 102), where each channel-shaped portion 128 is to receive a corresponding portion of second member 104, in this case, arm 114. Outer portion 106 may comprise one or more projections 130 extending in a direction substantially parallel to inner surface 126. Projections 130 may be snap-fit into a corresponding opening 132 located in a side of one of channel-shaped portions 128. (In general, a snap-fit assembly is one in which components are physically attached or engaged by one or more locking features that deform to enable the attachment or engagement, then "snap" back from the deformation to maintain or lock the attachment or engagement.) The formation of channel-shaped portions 128 and openings 132 in first member 102 may be done using progressive stamping. Although first member 102 and outer portion 106 of second member 104 may be generally rigid and durable, the constructions of these members may accommodate elastic deformation to enable or facilitate the snap-fitting. Once parts are snap-fit to one another, they are not readily separable from one another.

First member 102 may be formed before or after second member 104 or simultaneously with second member 104. First member 102 and second member 104 may be formed by the same manufacturer or by different manufacturers. For example, one or both of first member 102 and second member 104 may be delivered separately to a manufacturer for construction of subassembly 100.

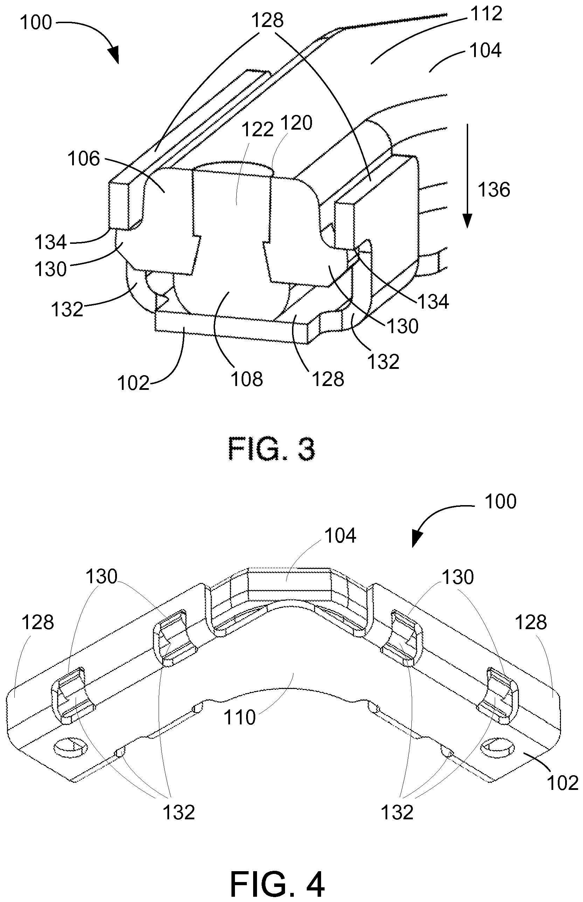

FIG. 3 illustrates a cross-sectional fragmentary view of example suspension and tolerance absorption subassembly 100 as illustrated in Fig. 1. In FIG.3, the subassembly is assembled, with assembled second member 104 (which includes outer portion 106 and flexible inner portion 108) mated to first member 102. As described with respect to FIG. 2, in addition to any chemical bond that may be formed at the surface(s) of contact between outer portion 106 and inner portion 108 of second member 104, a mechanical bond may also be formed by the engagement of protrusions 122 of inner portion 108 with holes 120 of outer portion 106, preventing separation of portions 106 and 108.

The snap-fit between first member 102 and second member 104 is apparent from a joint 134 formed between each projection 130 of outer portion 106 of second member 104 and each opening 132 of first member 102. Projections 130 may be (for example) hook-shaped so as to prevent ready separation of second member 104 from first member 102.

Notably, the size of openings 132 may be larger than projections 130 being accommodated in openings 132. As a result, the extended size of openings 132 may permit limited movement of second member 104 relative to first member 102 in a direction illustrated by an arrow 136. For example, outer surface 112 of second member 104 may be brought closer to inner surface 128 of first member 102 upon compression of flexible inner portion 108. Motion in the direction opposite to arrow 136 may be constrained by joint 134, and motion orthogonal to arrow 136 may be constrained as well.

It is the flexibility of inner portion 108 of second member 104 that assists in the absorption of shock, vibration and mechanical tolerances, thereby enabling each subassembly 100 to act as a cushioning support for a display screen secured to a PCB. For example, subassembly 100 may reduce or prevent damage to a display screen of an electronic device that might normally result from shock and/or vibration associated with dropping the electronic device. Subassembly 100 may also provide cushioning to a display screen with touch-screen functionality, such that subassembly 100 may reduce or prevent damage to the display screen resulting from pressure applied by the user's finger. In another example, subassembly 100 may reduce stress to the display screen caused by deviations from the nominal dimensions of one or more of components of the electronic device.

FIG. 4 illustrates a bottom perspective view of the example suspension and tolerance absorption subassembly illustrated in FIG. 1. As described with respect to FIG. 2, second member 104 of subassembly 100 is snap-fit into first member 102 by snapping projections 130 of second member 104 into openings 132 of channel-shaped portions 128 of first member 102.

Although the concepts described herein are not necessarily restricted to particular materials, shapes or modes of assembly, many of the implementations (including the example implementations depicted in the figures) may advantageously aid in assembly. For example, second member 104 may be snap-fit into first member 102 forming subassembly 100, and subassembly 100 may be mounted on a PCB using surface mount technology (SMT) component placement systems, also known as pick-and-place robotic machines. Pick-and-place technology is a cost-effective means of placing surface mount components (SMCs) onto printed circuit boards with a high degree of accuracy. SMCs may be supplied on paper or plastic tape. In one example, a tape assembly comprises a cavity tape, a cover tape, and one or more SMCs held between the cavity tape and the cover tape. Reels of this tape may be loaded onto feeders mounted to the pick-and-place machine. These feeders are known as tape-and-reel feeders. The pick-and-place machine normally uses suction nozzles to pick up individual components from tape-and-reel feeders, to rotate the components to the correct orientation and to place them on the appropriate locations on the PCB with high precision. The ability to position subassembly 100 on a PCB may be advantageous in the assembly of an electronic device, and the advantages may be terms of efficiency, speed, cost, quality, and shock absorption, for example. Multiple subassemblies 100 may be supplied on a tape for mounting on a PCB using pick-and-place technology. For example, a tape assembly may comprise one or more subassemblies 100 held between a cavity tape and a cover tape.

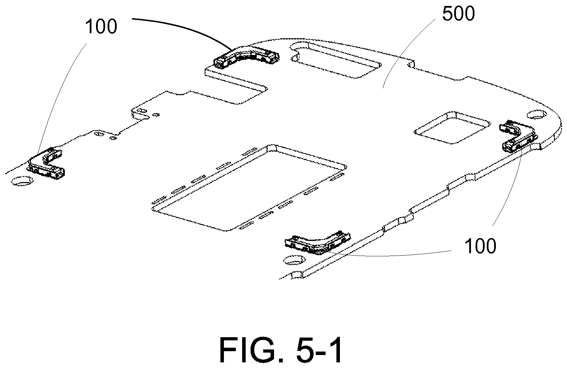

Subassembly 100 may be temporarily secured to the PCB at the desired location by solder paste. Solder paste may have been applied to the PCB earlier. More than one subassembly 100 may be mounted on a PCB for support of a display screen. For example, as illustrated in FIG. 5-1, four subassemblies 100 may be mounted on a PCB 500 at positions substantially corresponding to four corners of a display screen to be supported by subassemblies 100. In another example, alternate or additional subassemblies 100 may be mounted on PCB 500 for support of a display screen, for example, at other positions substantially corresponding to the periphery of the display screen or substantially corresponding to the middle of the display screen, or any other positions.

Once subassemblies 100 have been temporarily secured at the desired location, the entire assembly, including the PCB, the temporarily secured subassemblies 100, and any other surface mount components that have been mounted on or temporarily secured to the PCB, may be subjected to controlled heat to melt the solder paste and permanently connect subassemblies 100 to the PCB. This may be accomplished by passing the entire assembly through a reflow oven. As noted previously, subassembly 100 may comprise materials that are able to withstand reflow oven temperatures. Notably, solder may serve at least two distinct functions: adhering components to one another, and forming one or more electrical connections. In the case of the subassembly 100, there need not be any electrical connections (as subassembly 100 does not need any electrical components), so soldering may serve principally as an adhesive that affixes subassembly 100 to the PCB.

Following the reflow process, a display screen may be positioned such that its rear surface (which is opposite the front surface that displays images) is proximate to (and typically in contact with) outer surface 112 of outer portion 106 of second member 104 of each subassembly 100. The display screen may be a liquid crystal display (LCD) screen, an organic electroluminescent (OEL) display screen, an inorganic electroluminescent display screen, or any other display screen. In a variation, one or more subassemblies 100 may be mounted (e.g., by adhesive) to the display screen itself, and may bear against the PCB.

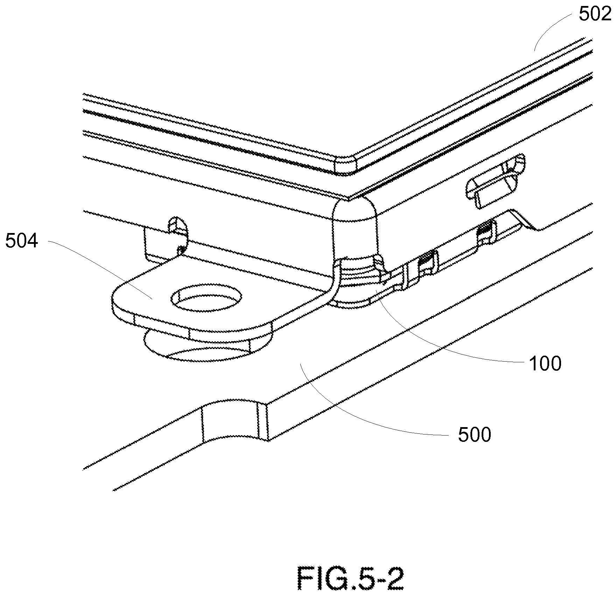

FIG. 5-2 illustrates a fragmentary perspective view of a display screen 502 being supported by one of subassemblies 100 mounted on PCB 500. There may be an electrical connection (not shown) between display screen 502 and PCB 500. Display screen 502 may be secured to PCB 500 using, for example, clips or screws or both or any other fasteners. For example, display screen 502 may be screwed down to PCB 500 through a tab 504. Subassembly 100 is interposed between display screen 502 and PCB 500, and spatially separates display screen 502 from PCB 500. Subassembly 100 may act as a cushion that prevents display screen 502 from being screwed down to a hard stop during mounting of the display screen 502 to the PCB 500. This may reduce stress on display screen 502 and prevent "hot spots" from forming on display screen 502.

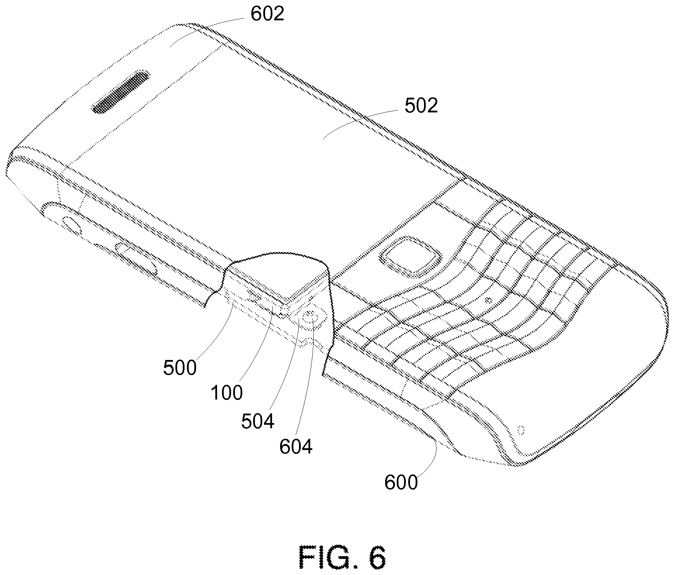

FIG. 6 illustrates a cutaway perspective view of display screen 502 being supported by one of subassemblies 100 mounted on PCB 500 within an electronic device 600. FIG. 6 shows the front surface of display screen 502. Electronic device 600 is illustrated as a mobile communications device. Within a housing 602 of electronic device 600, display screen 502 is screwed down to PCB 500 using one or more screws 604 through one or more corresponding tabs 504. PCB 500 is typically secured within housing 602, so that housing 602 and PCB 500 remain in a substantially fixed position with respect to one another. Housing 602 may be made or formed of any of several materials, typically rigid and durable materials such as plastic or metal.

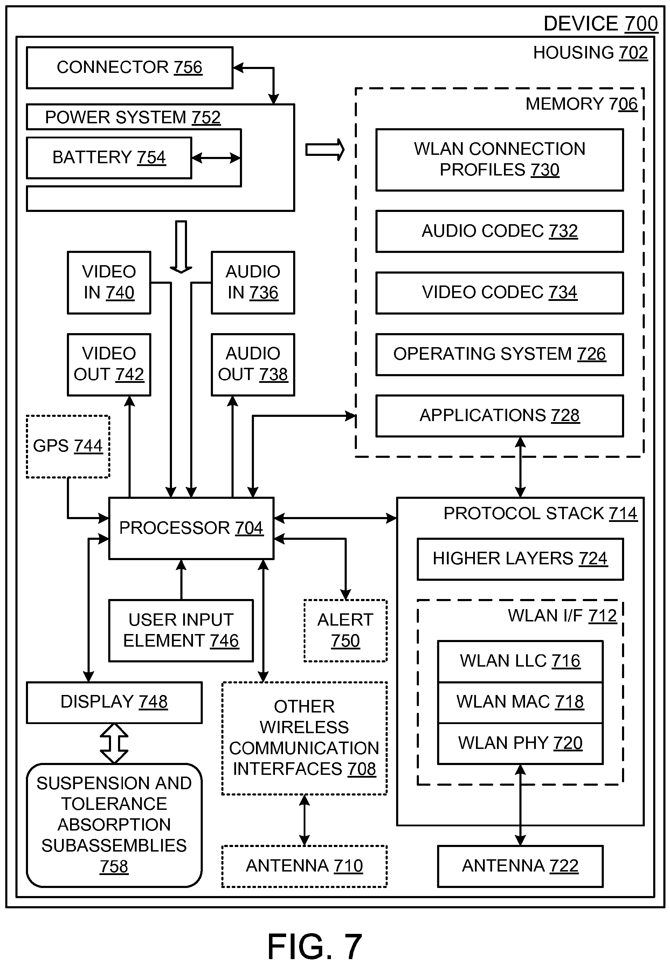

FIG. 7 is a simplified block diagram of an example mobile communications device 700. Device 700 is an example of electronic device 600. The components of device 700 are contained within a housing 702. Housing 702 is an example of housing 602.

Device 700 comprises a processor 704 coupled to a memory 706 and optionally to one or more other wireless communication interfaces 708. For example, other wireless communication interfaces 708 may comprise a short-range wireless communication interface such as a wireless personal area network interface, possibly compatible with Bluetooth®. In another example, other wireless communication interfaces 708 may comprise a wireless wide area network (WWAN) interface such as for cellular communications. One or more antennas 710 may be coupled to respective ones of the other wireless communication interfaces 708. An antenna may be shared among more than one wireless communication interface.

Device 700 also comprises a WLAN interface 712 within a protocol stack 714 that is coupled to processor 704. WLAN interface 712 comprises a WLAN LLC module 716, a WLAN MAC module 718 and a WLAN PHY module 720. WLAN MAC module 716 may be compatible with one or more standards of the family of IEEE 802.11 wireless communication standards. Device 700 also comprises an antenna 722 coupled to WLAN PHY module 720. Protocol stack 714 may comprise higher layers 724. Device 700 is able to communicate with a WLAN access point using WLAN interface 712.

Memory 706 may store an operating system 726 to be executed by processor 704. Memory 706 and processor 704, like many of the components described below, may be mounted to PCB 500 (which is not shown in FIG. 7). Memory 706 may store applications 728 installed in device 700 to be executed by processor 704. Memory 706 may also store data (not shown) used by operating system 726 and applications 728.

Memory 706 may store one or more WLAN connection profiles 730, each identifying a wireless local area network by its network name.

Memory 706 may store an audio coder-decoder (codec) 732 or a video codec 734 or both. A non-exhaustive list of examples for audio codec 732 includes G.711, G.722, G.723, G.726, G.729, MP3, Windows® Media Audio (WMA), Vector Sum Excited Linear Prediction (VSELP), Digital Speech Standard (DSS), and any other suitable audio codec. A non-exhaustive list of examples for video codec 734 includes H.261, H.263, H.264, flavors of Moving Picture Experts Group (MPEG), RealVideo®, Windows® Media Video, DivX®, Pixlet®, and any other suitable video codec.

Device 700 may comprise an audio input element 736 and an audio output element 738, both coupled to processor 704. Device 700 may comprise a video input element 740 and a video output element 742, both coupled to processor 704.

For example, applications 728 may comprise a VoIP application that works together with audio input element 736, audio output element 738, and audio codec 732. In another example, applications 728 may comprise a videoconferencing application that works together with audio input element 736, audio output element 738, audio codec 732, video input element 740, video output element 742, and video codec 734.

Device 700 may optionally comprise a Global Positioning System (GPS) module 744 coupled to processor 704.

Device 700 may comprise one or more user input elements 746 coupled to processor 704. Examples of user input elements include a keyboard, a keypad, a touch screen, a joystick, a thumbwheel, a roller, a touchpad, an optical pad, and the like.

Device 700 comprises a display screen 748 coupled to processor 704, where display screen 748 is a user output element of device 700. In the event that display screen 748 is a touch screen, it functions also as a user input element of device 700. Device 700 may comprise one or more additional user output elements coupled to processor 704.

Device 700 may optionally comprise one or more alert components 750 coupled to processor 704, to be activated in order to alert a user, for example, by sounding a buzzer, playing a ringtone, or vibrating.

Device 700 comprises a power system 752, one or more batteries 754 coupled to power system 752, and a connector 756 coupled to power system 752. Connector 756 is connectible to an external power source (not shown) to provide power for charging a power supply such as batteries 754 or for operating device 700 or for both. Power system 752 provides electrical coupling between the external power source and batteries 754, and provides electrical coupling between batteries 754 and the electrical components of device 700 (e.g. processor 704, memory 706, and the like). As part of the electrical coupling between the external power source and batteries 754, power system 752 may control the charging of batteries 754 with electrical charge drawn from the external power source.

Display screen 748 bears against and is supported by one or more suspension and tolerance absorption subassemblies 758 positioned between display screen 748 and the PCB to which display screen 748 is secured. (The double-ended arrow on FIG. 7 between display screen 748 and subassemblies 758 indicates a mechanical, rather than an electronic or signal-based, relationship between display screen 748 and subassemblies 758.) Subassemblies 758 are examples of subassembly 100. Each of subassemblies 758 is able to act as an independent suspension for display screen 748 and is able to cushion display screen 748 by absorbing mechanical tolerances and mechanical shock and vibration. With subassemblies 758, display screen 748 (or a portion thereof) has some restricted freedom to move in a direction toward the PCB. Movement toward the PCB is constrained by the cushioning of the subassemblies 758. In some circumstances (such as when display screen 748 has been pushed toward the PCB), the display screen 748 (or a portion thereof) has some restricted freedom to move in a direction away from the PCB, but this movement may be constrained by subassemblies 758 and the fasteners that secure display screen 748 to the PCB. Movement of display screen 748 in other directions (e.g., in any direction substantially parallel to a plane of the PCB) may likewise be constrained by subassemblies 758 and the fasteners.

Device 700 may comprise other elements that, for clarity, are not illustrated in FIG. 7. Similarly, device 700 may comprise a subset of the elements illustrated in FIG. 7.

One or more implementations may be used to realize one or more benefits, some of which have been mentioned already. Various implementations offer support and shock absorption for a display screen (an element that may be susceptible to damage in an impact), while also constraining the motion of the display screen with respect to the PCB or the housing. The shock absorption supplied by the subassemblies may address the stresses or forces or impacts-whether applied intentionally or unintentionally-that a display screen on a portable electronic device foreseeably may encounter. The shock absorption may help protect not only the display screen, but also the PCB, from damage. Further, various implementations may offer the capability for the display screen to be depressed on its front surface and to return (by the springiness of the cushioning of the subassemblies) to a neutral starting position. In other words, the subassemblies may supply protection against shocks, and may also supply the resilience to move a displaced display screen back to neutral starting position. Functions such as these can be performed without expenditure of electrical energy. Various implementations also support simplicity or efficiency of assembly, in that the subassemblies may have few moving parts and may be assembled using conventional techniques. In addition, a number of the implementations of the subassemblies may be capable of being affixed to a PCB in a procedure in which other components (such as electronic components) are affixed to the PCB; such techniques for assembly may be especially efficient in circumstances in which the electronic device has extended functionality and may have a substantial number of components affixed to the PCB. Many implementations of the subassembly offer a small "footprint," taking relatively little space on the PCB.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims. Further, as described herein, various elements may be in physical relationship with one another, such as being in contact with or bearing against one another. It is not always necessary, however, that the elements have such relationship directly. For example, two elements may be in contact with one another via an intervening element, or one element may bear against an interposing structure that in turn bears against the other element.

## Claims

1. An electronic device (600, 700) comprising:
a printed circuit board (500);
a display screen (502, 748) secured to the printed circuit board (500); and
a suspension and tolerance absorption subassembly (100, 758) mounted to the printed circuit board (500) and interposed between the display screen (502, 748) and the printed circuit board (500), wherein the suspension and tolerance absorption subassembly (100, 758) comprises:
a first member (102) affixed to the printed circuit board (500); and
a second member (104) having an outer portion (106) bearing against a rear surface of the display screen (502, 748) and a flexible inner portion (108) bearing against the outer portion (106) and the first member (102),
**characterised in that** the outer portion (106) of the second member (104) is substantially rigid and **in that** the first member (102) and the second member (104) are attached by a snap-fit assembly (130, 132), the snap-fit assembly having openings (132) in the first member (102) larger than projections (130) on the outer portion of the second member to permit limited movement of the second member relative to the first member.

2. The electronic device (600, 700) as claimed in claim 1, further **characterised in that** the first member (102) comprises steel.

3. The electronic device (600, 700) as claimed in claim 2, further **characterised in that** the first member (102) comprises stainless steel.

4. The electronic device (600, 700) as claimed in any one of claims 1 to 3, further **characterised in that** the outer portion (106) of the second member (104) comprises plastic.

5. The electronic device (600, 700) as claimed in claim 4, further **characterised in that** the outer portion (106) of the second member (104) comprises injection molded siloxane copolymer resin.

6. The electronic device (600, 700) as claimed in any one of claims 1 to 5, further **characterised in that** the flexible inner portion (108) of the second member (104) comprises rubber.

7. The electronic device (600, 700) as claimed in claim 6, further **characterised in that** the flexible inner portion (108) of the second member (104) comprises silicone rubber co-molded to the outer portion (106) of the second member (104).

8. The electronic device (600, 700) as claimed in any one of claims 1 to 7, further **characterised in that** the first member (102) comprises one or more channel-shaped portions (128), each channel-shaped portion (128) to receive a corresponding portion (114) of the second member (104).

9. The electronic device (600, 700) as claimed in any one of claims 1 to 8, further **characterised in that** the flexible inner portion (108) of the second member (104) comprises one or more protrusions (122,124) to fill one or more corresponding recesses (120) in the outer portion (106) of the second member (104).

10. The electronic device (600, 700) as claimed in any one of claims 1 to 9, further comprising a housing (602, 702), wherein the printed circuit board (500) is secured within the housing (602, 702).

11. The electronic device (600, 700) as claimed in any one of claims 1 to 10, wherein the display screen (502, 748) is a liquid crystal display.

12. The electronic device (600, 700) as claimed in any one of claims 1 to 11, wherein the display screen (502, 748) comprises four corners, further **characterised in that** the electronic device (600, 700) further comprises four of the subassemblies (100, 758), each of the four subassemblies (100, 758) having an L-shaped configuration and mounted on the printed circuit board (500) at a position substantially corresponding to a corner of the display screen (502, 748).

## Patentansprüche

1. Elektronikvorrichtung (600, 700) mit:
einer Platine (500),
einem Anzeigebildschirm (502, 748), der an der Platine (500) befestigt ist, und
einer Aufhängungs- und Toleranzabsorptionsunterbaugruppe (100, 758), die an der Platine (500) angebracht ist und zwischen dem Anzeigebildschirm (502, 748) und der Platine (500) eingeschoben ist, wobei die Aufhängungs- und Toleranzabsorptionsunterbaugruppe (100, 758) Folgendes aufweist:
ein erstes Element (102), das an der Platine (500) fixiert ist, und
ein zweites Element (104), das einen äußeren Abschnitt (106), der gegen eine hintere Oberfläche des Anzeigebildschirms (502, 748) drückt, und einen flexiblen inneren Abschnitt (108) hat, der gegen den äußeren Abschnitt (106) und das erste Element (102) drückt,
**dadurch gekennzeichnet, dass** der äußere Anschnitt (106) des zweiten Elements (104) im Wesentlichen starr ist und dass das erste Element (102) und das zweite Element (104) durch eine Schnappverbindungsbaugruppe (130, 132) befestigt sind, wobei die Schnappverbindungsbaugruppe Öffnungen (132) in dem ersten Element (102) hat, die größer als Erhebungen (130) auf dem äußeren Abschnitt des zweiten Elements sind, um eine begrenzte Bewegung des zweiten Elements relativ zu dem ersten Element zu erlauben.

2. Elektronikvorrichtung (600, 700) nach Anspruch 1, ferner **dadurch gekennzeichnet, dass** das erste Element (102) Stahl aufweist.

3. Elektronikvorrichtung (600, 700) nach Anspruch 2, ferner **dadurch gekennzeichnet, dass** das erste Element (102) rostfreien Stahl aufweist.

4. Elektronikvorrichtung (600, 700) nach einem der Ansprüche 1 bis 3, ferner **dadurch gekennzeichnet, dass** der äußere Abschnitt (106) des zweiten Elements (104) Kunststoff aufweist.

5. Elektronikvorrichtung (600, 700) nach Anspruch 4, ferner **dadurch gekennzeichnet, dass** der äußere Abschnitt (106) des zweiten Elements (104) ein spritzgegossenes Siloxan-Copolymer-Harz aufweist.

6. Elektronikvorrichtung (600, 700) nach einem der Ansprüche 1 bis 5, ferner **dadurch gekennzeichnet, dass** der flexible innere Abschnitt (108) des zweiten Elements (104) Gummi aufweist.

7. Elektronikvorrichtung (600, 700) nach Anspruch 6, ferner **dadurch gekennzeichnet, dass** der flexible innere Abschnitt (108) des zweiten Elements (104) Silikongummi bzw. Silikonkautschuk aufweist, der mit dem äußeren Abschnitt (106) des zweiten Elements zusammengeformt bzw. zusammengegossen ist (104).

8. Elektronikvorrichtung (600, 700) nach einem der Ansprüche 1 bis 7, ferner **dadurch gekennzeichnet, dass** das erste Element (102) einen oder mehrere kanalförmige Abschnitte (128) aufweist, wobei jeder kanalförmige Abschnitt (128) dazu dient, einen entsprechenden Abschnitt (114) des zweiten Elements (104) aufzunehmen.

9. Elektronikvorrichtung (600, 700) nach einem der Ansprüche 1 bis 8, ferner **dadurch gekennzeichnet, dass** der flexible innere Abschnitt (108) des zweiten Elements (104) einen oder mehrere Vorsprünge (122, 124) aufweist, um einen oder mehr entsprechende Rücksprünge (120) in dem äußeren Abschnitt (106) des zweiten Elements (104) zu füllen.

10. Elektronikvorrichtung (600, 700) nach einem der Ansprüche 1 bis 9, ferner mit einem Gehäuse (602, 702), wobei die Platine (500) innerhalb des Gehäuses (602, 702) gesichert ist.

11. Elektronikvorrichtung (600, 700) nach einem der Ansprüche 1 bis 10, wobei der Anzeigebildschirm (502, 748) eine Flüssigkristallanzeige ist.

12. Elektronikvorrichtung (600, 700) nach einem der Ansprüche 1 bis 11, wobei der Anzeigebildschirm (502, 748) vier Ecken aufweist, ferner **dadurch gekennzeichnet, dass** die Elektronikvorrichtung (600, 700) ferner vier der Unterbaugruppen (100, 758) aufweist, wobei jede der vier Unterbaugruppen (100, 758) eine L-förmige Konfiguration hat und auf der Platine (500) an einer Stelle angebracht ist, die im Wesentlichen einer Ecke des Anzeigebildschirms (502, 748) entspricht.

## Revendications

1. Dispositif électronique (600, 700), comprenant :
une carte de circuits imprimés (500) ;
un écran d'affichage (502, 748) fixé à la carte de circuits imprimés (500) ; et
un sous-ensemble de suspension et d'absorption de tolérances (100, 758) monté sur la carte de circuits imprimés (500) et interposé entre l'écran d'affichage (502, 748) et la carte de circuits imprimés (500), le sous-ensemble de suspension et d'absorption de tolérances (100, 758) comprenant :
un premier élément (102) fixé à la carte de circuits imprimés (500) ; et
un deuxième élément (104) comportant une partie extérieure (106) portant contre une surface arrière de l'écran d'affichage (502, 748) et une partie intérieure souple (108) portant contre la partie extérieure (106) et le premier élément (102),
**caractérisé en ce que** la partie extérieure (106) du deuxième élément (104) est sensiblement rigide et **en ce que** le premier élément (102) et le deuxième élément (104) sont fixés par un ensemble d'adaptation par encliquetage (130, 132), l'ensemble d'adaptation par encliquetage comportant des ouvertures (132) dans le premier élément (102) qui sont plus grandes que des saillies (130) sur la partie extérieure du deuxième élément, de façon à permettre un mouvement limité du deuxième élément par rapport au premier élément.

2. Dispositif électronique (600, 700) selon la revendication 1, **caractérisé en outre en ce que** le premier élément (102) comprend de l'acier.

3. Dispositif électronique (600, 700) selon la revendication 2, **caractérisé en outre en ce que** le premier élément (102) comprend de l'acier inoxydable.

4. Dispositif électronique (600, 700) selon l'une quelconque des revendications 1 à 3, **caractérisé en outre en ce que** la partie extérieure (106) du deuxième élément (104) comprend une matière plastique.

5. Dispositif électronique (600, 700) selon la revendication 4, **caractérisé en outre en ce que** la partie extérieure (106) du deuxième élément (104) comprend une résine de copolymère de siloxane moulée par injection.

6. Dispositif électronique (600, 700) selon l'une quelconque des revendications 1 à 5, **caractérisé en outre en ce que** la partie intérieure souple (108) du deuxième élément (104) comprend du caoutchouc.

7. Dispositif électronique (600, 700) selon la revendication 6, **caractérisé en outre en ce que** la partie intérieure souple (108) du deuxième élément (104) comprend un caoutchouc aux silicones co-moulé avec la partie extérieure (106) du deuxième élément (104).

8. Dispositif électronique (600, 700) selon l'une quelconque des revendications 1 à 7, **caractérisé en outre en ce que** le premier élément (102) comprend une ou plusieurs parties en forme de canal (128), chaque partie en forme de canal (128) étant destinée à recevoir une partie correspondante (114) du deuxième élément (104).

9. Dispositif électronique (600, 700) selon l'une quelconque des revendications 1 à 8, **caractérisé en outre en ce que** la partie intérieure souple (108) du deuxième élément (104) comprend une ou plusieurs saillies (122, 124) pour remplir une ou plusieurs cavités correspondantes (120) dans la partie extérieure (106) du deuxième élément (104).

10. Dispositif électronique (600, 700) selon l'une quelconque des revendications 1 à 9, comprenant de plus un boîtier (602, 702), dans lequel la carte de circuits imprimés (500) est fixée à l'intérieur du boîtier (602, 702).

11. Dispositif électronique (600, 700) selon l'une quelconque des revendications 1 à 10, dans lequel l'écran d'affichage (502, 748) est un dispositif d'affichage à cristaux liquides.

12. Dispositif électronique (600, 700) selon l'une quelconque des revendications 1 à 11, dans lequel l'écran d'affichage (502, 748) comprend quatre coins, **caractérisé en outre en ce que** le dispositif électronique (600, 700) comprend de plus quatre des sous-ensembles (100, 758), chacun des quatre sous-ensembles (100, 758) ayant une configuration en forme de L et étant monté sur la carte de circuits imprimés (500) dans une position correspondant sensiblement à un coin de l'écran d'affichage (502, 748).
